# EUROPEAN PATENT SPECIFICATION

(11) **EP 2 565 976 B1**
(45) Date of publication and mention of the grant of the patent: **25.06.2014**
(21) Application number: 12181994.0
(22) Date of filing: 28.08.2012
(51) Int. Cl.: H01M 10/48, H01M 10/42, B60L 3/00, H02J 7/00, B60L 11/18, G01R 31/36

(54) **Assembled battery monitoring device, secondary battery apparatus, and vehicle**
Überwachungsvorrichtung eines Batteriemoduls, Sekundärbatterievorrichtung und Fahrzeug
Dispositif de surveillance de batterie assemblée, appareil de batterie secondaire et véhicule

(30) Priority: 30.08.2011 JP 2011187060
(43) Date of publication of application: 06.03.2013
(73) Proprietor: Kabushiki Kaisha Toshiba, Minato-ku, Tokyo 105-8001 (JP)
(72) Inventor: Yamane, Fumiyuki, Tokyo, 105-8001 (JP)
(74) Representative: Willquist, Sofia Ellinor

(56) References cited:
- EP-A2- 2 085 784
- WO-A1-2010/070423
- JP-A- 2009 222 628

## Description

### FIELD

Embodiments described herein relate generally to an assembled battery monitoring device, a secondary battery apparatus, and a vehicle.

### BACKGROUND

A secondary battery apparatus comprises a plurality of assembled batteries each including a plurality of secondary battery cells, an assembled battery monitoring device that monitor the assembled batteries, and an assembled battery management unit.

The assembled battery monitoring device comprises an inter-assembled-battery voltage balance control circuit configured to suppress a variation in voltage among the assembled batteries caused by a variation in amperage consumption among the assembled battery monitoring devices, and an assembled battery monitoring device power supply circuit that allow the assembled batteries to generate power required for operations in the assembled battery monitoring device.

The plurality of assembled battery monitoring devices involve a difference in amperage consumption, and this difference is equal to the sum of a static difference in amperage consumption determined by a difference among corresponding parts mounted in the respective assembled battery monitoring devices and a dynamic difference in amperage consumption determined by a difference in throughput. The difference in amperage consumption among the plurality of assembled battery monitoring devices varies the voltage among the assembled batteries.

Here, the static component is mostly determined by a variation in characteristics among the devices (thresholds for transistors). The dynamic component is mostly determined by a processing data pattern (whether or not to toggle values) and throughput (communication error processing). Both components are proportional to operating power supply voltage.

In recent years, in an increasing number of secondary battery apparatuses, most of functions mounted in the assembled battery monitoring device are integrated into assembled battery monitoring ICs. With most of the functions integrated into the assembled battery monitoring ICs, the assembled battery monitoring ICs account for about 90% of the amperage consumption of the assembled battery monitoring devices. This enhances the tendency that a variation in voltage among the assembled batteries is determined by a difference in amperage consumption among the assembled battery monitoring ICs.

The conventional technique fails to provide a mechanism for reducing the difference in amperage consumption among a plurality of assembled battery monitoring devices. Thus, the assembled battery monitoring device comprises an inter-assembled-battery voltage balance control circuit that equalizes the voltage among the assembled batteries.

The inter-assembled-battery voltage balance control circuit adjusts the voltages of all the assembled batteries to the voltage of an assembled battery with the lowest voltage. That is, the amperage consumptions of all the assembled battery monitoring devices are adjusted to the amperage consumption of an assembled battery monitoring device with the highest amperage consumption so that assembled batteries with higher voltages are discharged. Thus, reducing wasteful amperage consumption required to control the balance of the voltages of the assembled batteries has been difficult. This has led to a reduction in effectively available battery capacity.

### BRIEF DESCRIPTION OF THE DRAWINGS

FIG. 1 is a diagram schematically showing an example of configuration of a vehicle according to an embodiment;
FIG. 2 is a diagram illustrating an example of a configuration of a secondary battery apparatus according to the embodiment;
FIG. 3 is a diagram illustrating an example of configuration of an assembled battery monitoring device according to the embodiment;
FIG. 4 is a flowchart illustrating an example of an IC internal operating power supply voltage set value calculation process of an assembled battery monitoring IC;
FIG. 5 is a flowchart illustrating an example of a power consumption target correction value calculation process of the assembled battery monitoring IC;
FIG. 6 is a diagram illustrating an example of configuration in which the IC internal operating power supply voltage set value calculation process and power consumption target correction value calculation process of the assembled battery monitoring IC are carried out by an arithmetic control circuit via software;
FIG. 7 is a flowchart illustrating an example of processing carried out by an assembled battery management unit in setting an amperage consumption target value for the first time; and
FIG. 8 is a flowchart illustrating an example of processing carried out by the assembled battery management unit in changing the amperage consumption target value.

### DETAILED DESCRIPTION

In general, according to one embodiment, an assembled battery monitoring device comprises an assembled battery monitoring device power supply circuit which powered by an assembled battery comprising a plurality of secondary battery cells; and an assembled battery monitoring IC powered by the assembled battery monitoring device power supply circuit. The assembled battery monitoring IC comprises a coulomb counter circuit configured to measure internal amperage consumption; an IC internal power supply circuit powered by the assembled battery monitoring device power supply circuit to generate a power supply voltage for use for an internal operation; and a power supply voltage set value calculation module configured to calculate a set value for a power supply voltage generated by the IC internal power supply circuit so as to determine a first amperage consumption target value to be a first amperage consumption measured value measured at the first time interval by the coulomb counter circuit.

An assembled battery device, a secondary battery apparatus, and a vehicle will be described below with reference to the drawings.

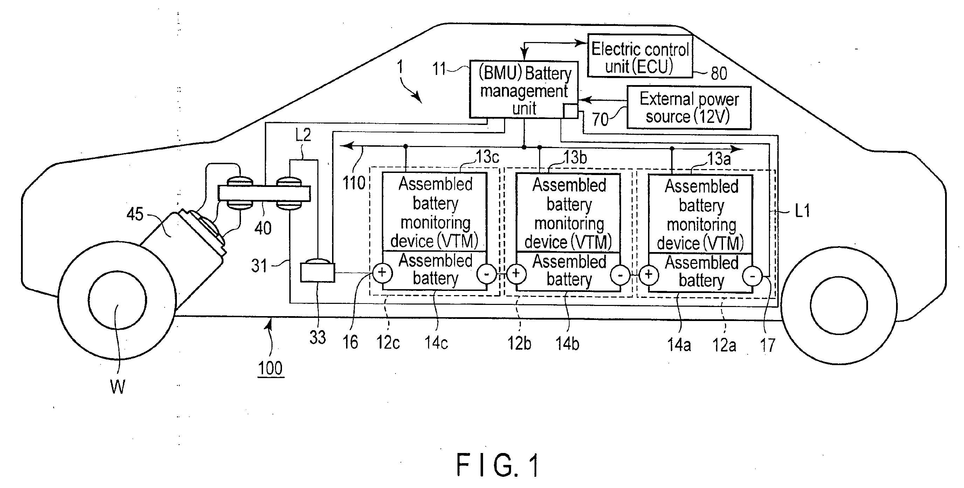

FIG. 1 is a diagram schematically showing an example of configuration of a vehicle according to an embodiment. In FIG. 1, a vehicle 100, an area in the vehicle 100 in which a secondary battery apparatus is mounted, a driving motor 45 for the vehicle 100, and the like are schematically shown.

The vehicle 100 comprises a secondary battery apparatus 1, an electric control unit (ECU) 80 that is higher controller for the secondary battery apparatus 1, an external power source 70, an inverter 40, and a driving motor 45.

The inverter 40 converts an input DC voltage into a high three-phase AC voltage for motor driving. The inverter 40 has its output voltage controlled based on a control signal from the electric control unit 80 which controls an assembled battery management unit 11 or the whole vehicle. Three-phase output terminals of the inverter 40 are connected to respective three-phase input terminals of the driving motor 45.

The driving motor 45 is rotated by power supplied by the inverter 40, and transmits the rotation to an axle and a driving wheel W.

One end of a connection line L1 is connected to a negative pole terminal 17 of the secondary battery apparatus 1. The connection line L1 is connected to a negative pole input terminal 17 of the inverter 40 via a current detection section (not shown in the drawings) in the assembled battery management unit 11.

One end of a connection line L2 is connected to a positive pole terminal 16 of the secondary battery apparatus 1 via a switch apparatus 33. The other terminal of the connection line L2 is connected to a positive pole input terminal of the inverter 40.

An independent external power source 70 is connected to the assembled battery management unit 11 described below. The external battery 70 is a lead-acid battery rated at 12V. Furthermore, the assembled battery management unit 11 is connected to the electric control unit 80, which manages the whole vehicle in response to operating inputs from a driver or the like. Data on the maintenance of the secondary battery apparatus such as the remaining capacity of secondary battery cells is transferred between the assembled battery management unit 11 and the electric control unit 80 via a communication line.

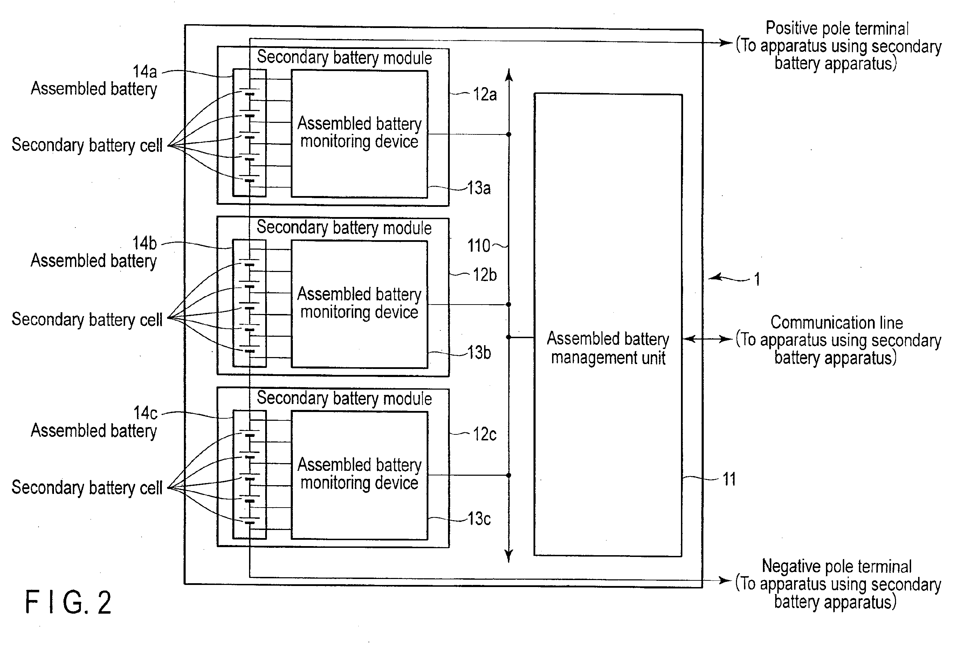

FIG. 2 is a diagram showing an example of configuration of the secondary battery apparatus 1 according to the present embodiment. The secondary battery apparatus 1 is connected to, for example, an electric car or a power accumulation system. The secondary battery apparatus 1 comprises a plurality of secondary battery modules 12a, 12b, and 12c connected together in series, the assembled battery management unit (BMU: battery management unit) 11, and a communication bus 110 that connects the secondary battery modules 12a, 12b, and 12c to the assembled battery management unit 11.

The secondary battery module 12a comprises an assembled battery 14a and an assembled battery monitoring (VTM: Voltage Temperature Monitoring) device 13a. The secondary battery module 12b comprises an assembled battery 14b and an assembled battery monitoring device 13b. The secondary battery module 12c comprises an assembled battery 14c and an assembled battery monitoring device 13c. The secondary battery modules 12a, 12b, and 12c can be independently disconnected from one another and replaced with other secondary battery modules. In the example in FIG. 2, the three secondary battery modules 12a to 12c are provided. However, the present invention is not limited to the three secondary battery modules and a single secondary battery module may be provided.

Each of the assembled batteries 14a to 14c comprises a plurality of secondary battery cells connected together in series and in parallel. The assembled batteries 14a to 14c are charged and discharged through the positive pole terminal 16 and the negative pole terminal 17. The secondary battery cells are, for example, lithium ion batteries. The secondary battery cells are not limited to the lithium ion batteries but may be any other battery cells such as nickel hydrogen batteries, lead-acid batteries, or nickel cadmium batteries.

In order to collect information on the maintenance of the secondary battery apparatus 1, the assembled battery management unit 11 communicates and collects information such as the voltages, temperatures, and the like of the secondary battery cells in the assembled batteries 14a to 14c included in the secondary battery apparatus 1, among the assembled battery monitoring devices 13a to 13c.

A communication bus 110 is connected between the assembled battery management unit 11 and the assembled battery monitoring devices 13a to 13c. The communication bus 110 is configured such that one set of communication lines is shared by a plurality of nodes (the assembled battery management unit and at least one assembled battery monitoring device). The communication bus 110 is configured based on, for example, a CAN (Control Area Network) standard.

The assembled battery monitoring devices 13a to 13c measure the voltages and temperatures of the individual secondary battery cells forming the assembled batteries 14a to 14c, based on an instruction communicated by the assembled battery management unit 11. However, the temperature may be measured at only several positions on each assembled battery, and not all the secondary battery cells need to be subjected to temperature measurement.

The secondary battery apparatus 1 may comprise an electromagnetic contactor (for example, a switch unit 33 shown in FIG. 1). The switch unit 33 includes a pre-charge switch (not shown in the drawings) that is turned on to charge the assembled batteries 14a to 14c and a main switch (not shown in the drawings) that is turned on to supply a battery output to a load. Each of the pre-charge switch and the main switch comprises a relay circuit (not shown in the drawings) that is turned on and off by a signal supplied to a coil arranged near the switch element.

Here, the assembled battery monitoring devices 13a to 13c involve a difference in amperage consumption that is equal to the sum of a static difference in amperage consumption determined by a difference among corresponding parts mounted in the respective assembled battery monitoring devices and a dynamic difference in amperage consumption determined by a difference in throughput. The difference in amperage consumption varies the voltage among the assembled batteries 14a to 14c.

The static component of the difference in amperage consumption is mostly determined by a variation in characteristics among the devices (thresholds for transistors). The dynamic component is mostly determined by a processing data pattern (whether or not to toggle values) and throughput (communication error processing). Both components are proportional to operating power supply voltage.

Furthermore, all or most of the components of the secondary battery apparatus 1 comprising the assembled battery monitoring devices 13a to 13c and the assembled battery management unit 11 are often formed of semiconductor integrated circuits (ICs). The tendency to integrate the components into semiconductor integrated circuits has been enhanced. As a result, the semiconductor integrated circuits mounted in the assembled battery monitoring devices 13a to 13c accounts for about 90% of the amperage consumption of the assembled battery monitoring devices 13a to 13c. The tendency that the difference in amperage consumption among the semiconductor integrated circuits varies the voltage among the assembled batteries 14a to 14c has been enhanced.

Thus, since the amperage consumption of the semiconductor integrated circuits mounted in the assembled battery monitoring devices 13a to 13c is proportional to the operating power supply voltage and the amperage consumption of the semiconductor integrated circuits determines the amperage consumption of the assembled battery monitoring devices 13a to 13c, the embodiment carries out the following. The operating power supply voltage inside the semiconductor integrated circuits is changed so as to make the amperage consumption of the semiconductor integrated circuits closer to an amperage consumption target value transmitted to the assembled battery monitoring devices 13a to 13c by the assembled battery management unit 11.

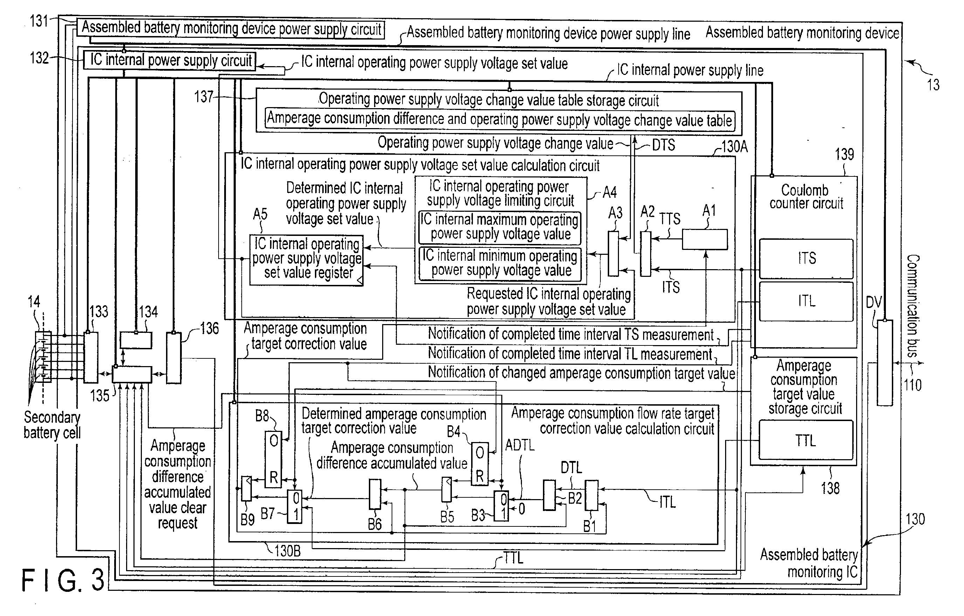

FIG. 3 shows an example of configuration of each of the assembled battery monitoring devices 13a to 13c. The assembled battery monitoring devices 13a to 13c have similar configurations, and thus in the description below, the assembled battery monitoring devices 13a to 13c are collectively referred to as the assembled battery monitoring device 13.

The assembled battery monitoring device 13 comprises an assembled battery monitoring IC 130, a communication driver circuit DV, and an assembled battery monitoring device power supply circuit 131.

The communication driver circuit DV converts communication signal levels for the assembled battery monitoring IC 130 into communication signal levels complying with a communication standard for the communication bus 110 connected to the assembled battery management unit 11, vice versa.

The assembled battery monitoring device power supply circuit 131 is powered by the assembled battery 14 to generate a power supply voltage required for the assembled battery monitoring IC 130 and the communication driver circuit DV.

The assembled battery monitoring IC 130 measures the voltages and temperatures of the plurality of secondary battery cells forming the assembled battery 14, processes the measurement data, and communicates with the assembled battery management unit 11.

The assembled battery monitoring IC 130 comprises an IC internal power supply circuit 132, a battery voltage and battery temperature measurement circuit 133, a storage circuit 134, an arithmetic control circuit 135, a communication circuit 136, an operating power supply voltage change value table storage circuit 137, an amperage consumption target value storage circuit 138, a coulomb counter circuit 139, an amperage consumption flow rate target correction value calculation module 130B, and an IC internal operating power supply voltage set value calculation circuit 130A.

The IC internal power supply circuit 132 is powered by the assembled battery monitoring device power supply circuit 131 to generate a power supply voltage required for the circuit inside the assembled battery monitoring IC 130. The IC internal power supply circuit 132 generates the power supply voltage so that the voltage is equal to an IC internal operating power supply voltage set value input to the IC internal power supply circuit 132 by the IC internal operating power supply voltage set value calculation circuit 130A described below.

The battery voltage and battery temperature measurement circuit 133 periodically measures the voltages and temperatures of the plurality of secondary battery cells forming the assembled battery 14. The battery voltage and battery temperature measurement circuit 133 detects the voltages of a positive pole terminal and a negative pole terminal of each of the plurality of secondary battery cells of the assembled battery 14. The battery voltage and battery temperature measurement circuit 133 comprises a temperature sensor (not shown in the drawings) arranged near the assembled battery 14 to detect the temperature of the assembled battery 14. The battery voltage and battery temperature measurement circuit 133 outputs data on the detected voltage and data on the detected temperature to the arithmetic control circuit 135.

The communication circuit 136 carries out protocol processing for communication between the communication circuit 136 and the assembled battery management unit 11 via the communication bus 110.

The arithmetic control circuit 135 controls the battery voltage and battery temperature measurement circuit 133, the communication circuit 136, and the amperage consumption target value storage circuit 138 to process the data received from the battery voltage and battery temperature measurement circuit 133 and the communication data. The arithmetic control circuit 135 calculates the voltages of the plurality of secondary battery cells from the voltages of the positive pole terminal and negative pole terminal of each of the plurality of secondary battery cells which voltages are received from the battery voltage and battery temperature measurement circuit 133. The arithmetic control circuit 135 outputs the calculated voltages to the communication circuit 136. Furthermore, the arithmetic control circuit 135 periodically outputs an amperage consumption accumulated value ATL to the communication circuit 136. The arithmetic control circuit 135 writes an amperage consumption target value TTL received from the assembled battery management unit 11 via the communication circuit 136, to the amperage consumption target value storage circuit 138.

The storage circuit 134 stores a program describing the contents of the processing by the arithmetic control circuit 135 and data required for the processing by the arithmetic control circuit 135.

The amperage consumption target value storage circuit 138 stores a target value for amperage consumption expressed in units of a certain time unit (hereinafter referred to as a time interval TL) transmitted by the assembled battery management unit 11 via the communication bus 110a (this target value is hereinafter referred to as an amperage consumption target value TTL). The amperage consumption target value storage circuit 138 outputs the amperage consumption target value TTL and a notification of changed amperage consumption target value to the amperage consumption flow rate target correction value calculation module 130B.

The coulomb counter circuit 139 measures the amount of current consumed by the assembled battery monitoring IC 130. The coulomb counter circuit 139 comprises a module configured to measure the amperage consumption of the assembled battery monitoring IC 130 for the time interval TL (this amperage consumption is hereinafter referred to as an amperage consumption measured value ITL) and module for measure the amperage consumption at a time interval (hereinafter referred to as a time interval TS) shorter than the time interval TL (this amperage consumption is hereinafter referred to as an amperage consumption measured value ITS). The coulomb counter circuit 139 outputs the amperage consumption measured values ITL and ITS, a notification of completed time interval TS measurement, and a notification of completed time interval TL measurement. The time interval TL is equal to the time interval TS multiplied by a predetermined number.

The operating power supply voltage change value table storage circuit 137 stores a table indicative of the relationship between an amperage consumption difference DTS calculated by the IC internal operating power supply voltage set value calculation circuit 130A and the amount of change in IC internal operating power supply voltage (this amount is denoted by V). Upon receiving the input amperage consumption difference DTS, the operating power supply voltage change value table storage circuit 137 references an amperage consumption difference-operating power supply voltage change value table to output an operating power supply voltage change value corresponding to the input amperage consumption DTS.

The IC internal operating power supply voltage set value calculation circuit 130A calculates the value of the operating power supply voltage inside the assembled battery monitoring IC with respect to the IC internal power supply circuit (IC internal operating power supply voltage set value), based on the difference (amperage consumption difference DTS) between a value resulting from conversion, based on the time interval TS, of the amperage consumption target correction value calculated by the amperage consumption flow rate target correction value calculation module 130B and the amperage consumption measured value ITS measured by the coulomb counter circuit 139.

The IC internal operating power supply voltage set value calculation circuit 130A comprises a time interval conversion circuit A1, a subtracter A2, an adder A3, an IC internal operating power supply voltage limiting circuit A4, and an IC internal operating power supply voltage set value register A5.

The time interval conversion circuit A1 receives, as an input, the amperage consumption target correction value output by the amperage consumption flow rate target correction value calculation module 130B described below. The time interval conversion circuit A1 converts the amperage consumption target correction value for the time interval TL, based on the time interval TS. The time interval conversion circuit A1 outputs an amperage consumption target value TTS (= amperage consumption target correction value x time interval TS / time interval TL).

The subtracter A2 receives, as inputs, amperage consumption target value TTS and the amperage consumption measured value ITS output by the coulomb counter circuit 139. The subtracter A2 calculates the difference between the amperage consumption target value TTS and the amperage consumption measured value ITS. The subtracter A2 then outputs the difference to the operating power supply voltage change value table storage circuit 137.

The adder A3 receives, as inputs, the operating power supply voltage change value output by the operating power supply voltage change value table storage circuit 137 and the IC internal operating power supply voltage set value output by the IC internal operating power supply voltage set value register A5. The adder A3 calculates the sum of the operating power supply voltage change value and the IC internal operating power supply voltage set value (the sum is hereinafter referred to as a requested IC internal operating power supply voltage set value). The adder A3 outputs the requested IC internal operating power supply voltage set value to the IC internal operating power supply voltage limiting circuit A4.

The IC internal operating power supply voltage limiting circuit A4 holds the maximum value (IC internal maximum operating power supply voltage value) and minimum value (IC internal minimum operating power supply voltage value) of the power supply voltage for the assembled battery monitoring IC 130. The IC internal operating power supply voltage limiting circuit A4 receives the requested IC internal operating power supply voltage set value as an input. The IC internal operating power supply voltage limiting circuit A4 compares the input requested IC internal operating power supply voltage set value with the IC internal maximum operating power supply voltage value and the IC internal minimum operating power supply voltage value. The IC internal operating power supply voltage limiting circuit A4 then outputs a determined IC internal operating power supply voltage set value that is equal to or greater than the IC internal minimum operating power supply voltage value and is equal to or smaller than the IC internal maximum operating power supply voltage value.

That is, if the requested IC internal operating power supply voltage set value is equal to or greater than the IC internal minimum operating power supply voltage value and is equal to or smaller than the IC internal maximum operating power supply voltage value, the determined IC internal operating power supply voltage set value is equal to the requested IC internal operating power supply voltage set value. If the requested IC internal operating power supply voltage set value is smaller than the IC internal minimum operating power supply voltage value, the determined IC internal operating power supply voltage set value is equal to the IC internal minimum operating power supply voltage set value. If the requested IC internal operating power supply voltage set value is greater than the IC internal minimum operating power supply voltage value, the determined IC internal operating power supply voltage set value is equal to the IC internal maximum operating power supply voltage set value.

The IC internal operating power supply voltage set value register A5 receives, as inputs, the determined IC internal operating power supply voltage set value and the notification of completed time interval TS measurement output by the coulomb counter circuit 139. The IC internal operating power supply voltage set value register A5 holds the determined IC internal operating power supply voltage set value calculated as described above every time the notification of completed time interval TS measurement is input. The IC internal operating power supply voltage set value register A5 outputs an IC internal operating power supply voltage set value to the IC internal power supply circuit 132.

The amperage consumption flow rate target correction value calculation module 130B corrects the amperage consumption target value to an amperage consumption target correction value using a value obtained by accumulating, at every time interval TL, the difference between the amperage consumption target value TTL stored in the amperage consumption target value storage circuit 138 and the amperage consumption target value ITL measured by the coulomb counter circuit 139.

The amperage consumption flow rate target correction value calculation module 130B comprises a subtracter B1, adders B2 and B6, selectors B3 and B7, OR circuits B4 and B8, an amperage consumption difference accumulated value register B5, and an amperage consumption target correction value register B9.

The subtracter B1 receives, as inputs, the amperage consumption measured value ITL output by the coulomb counter circuit 139 and the amperage consumption target correction value output by the amperage consumption target correction value register B9. The subtracter B1 outputs the difference between the amperage consumption measured value ITL and the amperage consumption target correction value (amperage consumption difference DTL) to the adder B2.

The adder B2 receives, as inputs, the amperage consumption difference DTL output by the subtracter B1 and the amperage consumption difference accumulated value ATL output by the amperage consumption difference accumulated value register B5. The adder B2 outputs the sum of the amperage consumption difference DTL and the amperage consumption difference accumulated value ATL (the sum is hereinafter referred to as a determined amperage consumption different accumulated value ADTL) to the selector B3.

The selector B3 receives, as inputs, the determined amperage consumption different accumulated value ADTL output by the adder B2 and an amperage consumption difference accumulated value clear request output by the arithmetic control circuit 135. Upon receiving the input amperage consumption difference accumulated value clear request, the selector B3 resets the determined amperage consumption difference accumulated value ADTL to zero. The selector B3 continuously outputs the determined amperage consumption difference accumulated value ADTL until the next amperage consumption difference accumulated value clear request is input to the selector B3.

The OR circuit B4 receives, as inputs, the amperage consumption difference accumulated value clear request output by the arithmetic control circuit 135 and the notification of completed time interval TL measurement output by the coulomb counter circuit 139.

The amperage consumption difference accumulated value register B5 receives, as inputs, the output signal from the selector B3 and the output signal from the OR circuit B4. Every time the output signal from the OR circuit B4 is set to a high (H) level, that is, every time at least one of the notification of completed time interval TL measurement and the amperage consumption difference accumulated value clear request is set to the high (H) level, the amperage consumption difference accumulated value register B5 holds the determined amperage consumption difference accumulated value output by the selector B3. The amperage consumption difference accumulated value register B5 outputs the held value (amperage consumption difference accumulated value) to the adder B2, the adder B6, and the arithmetic control circuit 135.

The adder B6 receives, as inputs, the amperage consumption difference accumulated value ATL and the amperage consumption target correction value output by the amperage consumption target correction value register B9 described below. The adder B6 calculates the sum of the amperage consumption difference accumulated value ATL and the amperage consumption target correction value (the sum is hereinafter referred to as a determined amperage consumption target correction value). The adder B6 outputs the determined amperage consumption target correction value to the selector B7.

The selector B7 receives, as inputs, the determined amperage consumption target correction value, and the amperage consumption target value TTL and notification of changed amperage consumption target value output by the amperage consumption target value storage circuit 138. Upon receiving the notification of changed amperage consumption target value, the selector B7 outputs the amperage consumption target value TTL to the amperage consumption target correction value register B9. If the selector B7 fails to receive the notification of changed amperage consumption target value, the selector B7 outputs the determined amperage consumption target correction value to the amperage consumption target correction value register B9.

The OR circuit B8 receives, as inputs, the notification of changed amperage consumption target value output by the amperage consumption target value storage circuit 138 and the notification of completed time interval TL measurement output by the coulomb counter circuit 139.

The amperage consumption target correction value register B9 receives, as inputs, the output signal from the selector B7 and the output signal from the OR circuit B8. Every time the output signal from the OR circuit B8 is set to the high (H) level, that is, every time at least one of the notification of changed amperage consumption target value and the notification of completed time interval TL measurement and the amperage consumption difference accumulated value clear request is set to the high (H) level, the amperage consumption target correction value register B9 holds the determined amperage consumption target correction value or amperage consumption target value TTL output by the selector B7. The amperage consumption target correction value register B9 outputs the amperage consumption target correction value to the time interval conversion circuit A1, the subtracter B1, and the adder B6.

An example of operation of the above-described assembled battery monitoring IC will be described below.

The assembled battery management unit 11 transmits the amperage consumption target value TTL based on the time interval TL. In order to reduce the difference between the amperage consumption and the amperage consumption target value TTL based on the time interval TL, the assembled battery monitoring device 13 adjusts the IC internal operating power supply voltage based on the time interval TS, which is equal to the time interval TL divided by the predetermined number. The IC internal operating power supply voltage set value calculation circuit 130A calculates the IC internal operating power supply voltage set value based on the time interval TS.

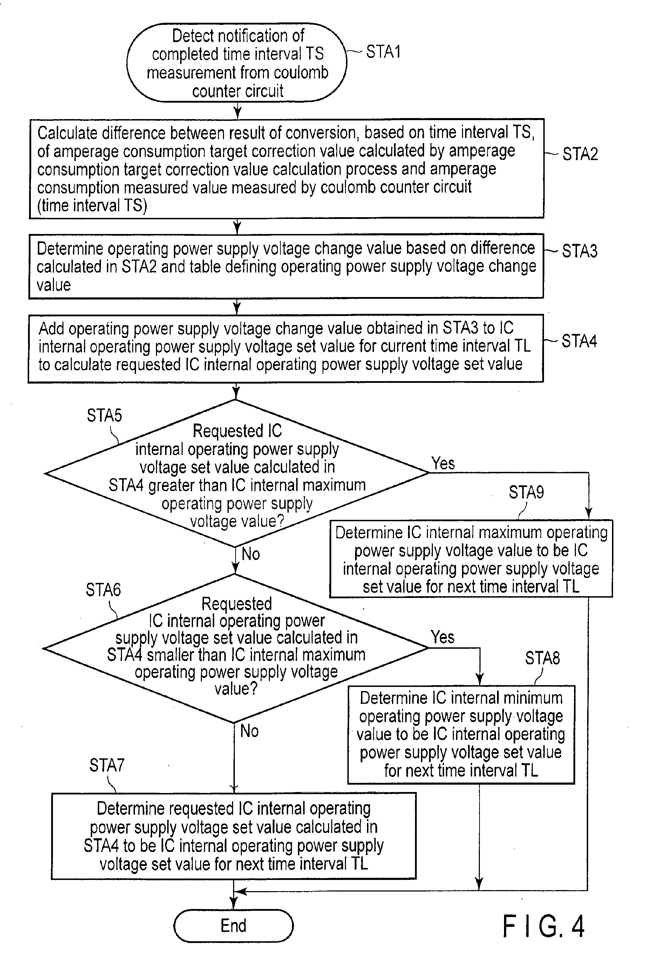

FIG. 4 is a flowchart illustrating an example of operation of the IC internal operating power supply voltage set value calculation circuit 130A in the assembled battery monitoring IC 130.

When the coulomb counter circuit 139 outputs the notification of completed time interval TS measurement, the IC internal operating power supply voltage set value calculation circuit 130A starts a process of calculating the IC internal operating power supply voltage set value (step STA1). The processing described below is carried out at each time interval TS using, as a trigger, the notification of completed time interval TS measurement from the coulomb counter circuit 139.

The time interval conversion circuit A1 converts the amperage consumption target value based on the time interval TL (amperage consumption target value TTL) into a value based on the time interval TS (amperage consumption target value TTS). The subtracter A2 calculates the difference (amperage consumption difference DTS) between the amperage consumption measured value ITS and amperage consumption target value TTS measured by the coulomb counter circuit 139 based on the time interval TS (step STA2).

Subsequently, the operating power supply voltage change value table storage circuit 137 outputs the operating power supply voltage change value corresponding to the amperage consumption difference DTS (step STA3).

Subsequently, the adder A3 adds the operating power supply voltage change value read from the operating power supply voltage change value table storage circuit 137 to the current IC internal operating power supply voltage set value. The adder A3 then outputs the result as a requested IC internal operating power supply voltage set value (step STA4).

Here, the operating power supply voltage inside the assembled battery monitoring IC involves the maximum operating power supply voltage and the minimum operating power supply voltage, at which the assembled battery monitoring IC is operative. The IC internal operating power supply voltage needs to fall within the range between the maximum operating power supply voltage and the minimum operating power supply voltage. Hence, the set value (IC internal operating power supply voltage set value) indicated to the IC internal power supply circuit 132, which generates an IC internal power supply, needs to be equal to or smaller than the maximum operating power supply voltage and to be equal to or greater than the minimum operating power supply voltage.

Thus, the IC internal operating power supply voltage limiting circuit A4 determines whether or not the requested IC internal operating power supply voltage set value output by the adder A3 is greater than the maximum operating power supply voltage (step STA5).

If the requested IC internal operating power supply voltage set value output by the adder A3 is greater than the maximum operating power supply voltage, the IC internal operating power supply voltage limiting circuit A4 determines the maximum operating power supply voltage value to be the IC internal operating power supply voltage set value (step STA9).

If the requested IC internal operating power supply voltage set value output by the adder A3 is equal to or smaller than the maximum operating power supply voltage, the IC internal operating power supply voltage limiting circuit A4 determines whether or not the requested IC internal operating power supply voltage set value is smaller than the minimum operating power supply voltage (step STA6).

If the requested IC internal operating power supply voltage set value is smaller than the minimum operating power supply voltage, the IC internal operating power supply voltage limiting circuit A4 determines the minimum operating power supply voltage value to be the IC internal operating power supply voltage set value (step STA8).

If the requested IC internal operating power supply voltage set value is equal to or greater than the minimum operating power supply voltage, the IC internal operating power supply voltage limiting circuit A4 determines the requested IC internal operating power supply voltage set value to be the IC internal operating power supply voltage set value (step STA7).

After carrying out the above-described limiting process, the IC internal operating power supply voltage limiting circuit A4 outputs the IC internal operating power supply voltage set value to the IC internal operating power supply voltage set value register A5.

The IC internal power supply circuit receives the value held in the IC internal operating power supply voltage set value register A5. The IC internal power supply circuit then changes the power supply voltage of the assembled battery monitoring IC 130 to the operating power supply voltage specified by the received set value.

The above-described processing enables a reduction in the difference based on the time interval TL. To reduce the accumulation of the difference between the remaining target amperage consumption and the actual amperage consumption, the amperage consumption flow rate target correction value calculation module 130B uses the accumulated value of the difference to calculate the amperage consumption target value TTL based on the time interval TL and used for the IC internal operating power supply voltage set value calculation circuit 130A.

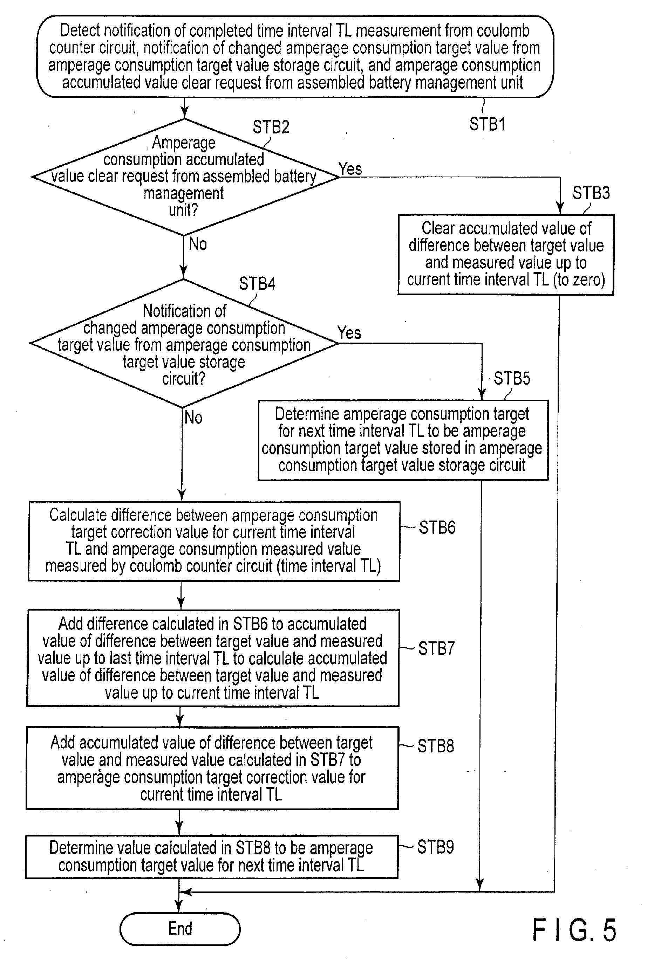

FIG. 5 is a flowchart illustrating an example of operation of the amperage consumption flow rate target correction value calculation module 130B in the assembled battery monitoring IC 130.

The amperage consumption flow rate target correction value calculation module 130B receives, as triggers, the notification of completed time interval TL measurement from the coulomb counter circuit 139, the notification of changed amperage consumption target value from the amperage consumption target value storage circuit 138, and the amperage consumption difference accumulated value clear request from the assembled battery management unit (step STB1).

If the assembled battery management unit 11 requests the arithmetic control circuit 135 to clear the amperage consumption difference accumulated value ATL to zero, the arithmetic control circuit 135 issues an amperage consumption difference accumulated value clear request (step STB2). If the amperage consumption difference accumulated value clear request is issued, the output from the selector B3 decreases to zero, and the output signal from the OR circuit B4 is set to the high (H) level. This clears the amperage consumption difference accumulated value ATL held in the amperage consumption difference accumulated value register B5 to zero (step STB3).

If the assembled battery management unit 11 first transmits the amperage consumption target value TTL or the assembled battery management unit 11 changes the amperage consumption target value TTL, the arithmetic control circuit 135 writes the amperage consumption target value TTL to the amperage consumption target value storage circuit 138. The amperage consumption target value storage circuit 138 outputs the notification of changed amperage consumption target value (step STB4).

If the notification of changed amperage consumption target value is output, the output from the selector B7 is set to the amperage consumption target value TTL held in the amperage consumption target value storage circuit B8, and the output signal from the OR circuit B8 is set to the high (H) level. The value held in the amperage consumption target correction value register B9 is a new value stored in the amperage consumption target value storage circuit 138 (step STB5).

If a trigger other than those described above is input, that is, if the notification of time interval TL measurement from the coulomb counter circuit 139 is input as a trigger, the processing described below is carried out at each time interval TL.

The subtracter B1 determines the difference (amperage consumption difference DTL) between the amperage consumption target value for the current time interval TL (amperage consumption target correction value) and the amperage consumption measured value ITL measured by the coulomb counter circuit 139 based on the time interval TL (step STB6).

Subsequently, the adder B2 calculates the determined amperage consumption difference accumulated value by adding the amperage consumption difference DTL to the accumulated value of the difference accumulated up to the last time interval TL (amperage consumption difference accumulated value ATL) (step STB7). The calculated determined amperage consumption difference accumulated value is held in the amperage consumption difference accumulated value register B5 as the amperage consumption difference accumulated value ATL.

Subsequently, the adder B6 adds the amperage consumption difference accumulated value ATL to the amperage consumption target correction value for the current time interval TL to calculate the determined amperage consumption target correction value (step STB8). The determined amperage consumption target correction value calculated by the adder B6 is held in the amperage consumption target correction value register B9.

The value held in the amperage consumption target correction value register B9 is output to the IC internal operating power supply voltage set value calculation circuit 130A as the amperage consumption target value for the next time interval TL (amperage consumption target correction value) (step STB9).

FIG. 3 shows an example in which the above-described processing is configured by the hardware mounted in the assembled battery monitoring IC 130. However, the above-described processing can be carried out by the arithmetic control unit 135, a component of the assembled battery monitoring IC 130, based on software describing the above-described processing.

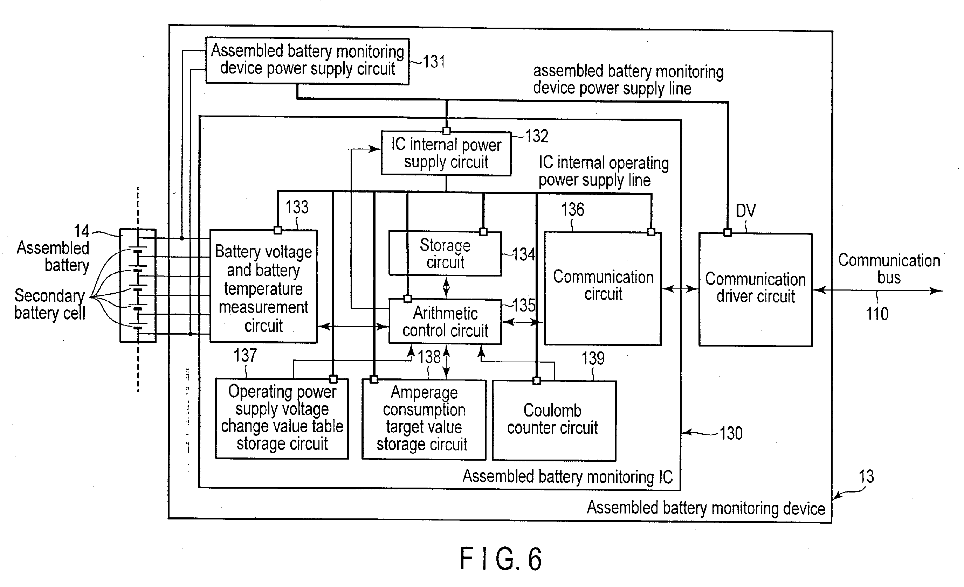

FIG. 6 shows an example of configuration of the assembled battery monitoring device 13 in which the above-described processing is carried out by the arithmetic control circuit 135 based on software describing the processing carried out by the IC internal operating power supply voltage set value calculation circuit 130A and the amperage consumption flow rate target correction value calculation module 130B. Components of the assembled battery monitoring device 13 in FIG. 6 which are similar to the corresponding components of the assembled battery monitoring device 13 shown in FIG. 3 are denoted by the same reference numerals. In the description below, components different from the components of the assembled battery monitoring device 13 shown in FIG. 3 will be described, with duplicate descriptions omitted.

The storage circuit 134 stores a program describing the above-described processing carried out by the arithmetic control circuit 135.

The arithmetic control circuit 135 receives the amperage consumption measured value ITL, the amperage consumption measured value ITS, the notification of completed time interval TL measurement, and the notification of completed time interval TS measurement from the coulomb counter circuit 139 as inputs. The arithmetic control circuit 135 also receives the amperage consumption target value TTL and the notification of changed amperage consumption target value from the amperage consumption target value storage circuit 138 as inputs.

The arithmetic control circuit 135 outputs the amperage consumption difference DTS calculated during the above-described processing.to the operating power supply voltage change value table storage circuit 137. The arithmetic control circuit 135 reads the operating power supply voltage change value corresponding to the amperage consumption difference DTS from the operating power supply voltage change value table storage circuit 137.

The arithmetic control circuit 135 reads the program stored in the storage circuit 134, and uses the information received from the coulomb counter circuit 139, the amperage consumption target value storage circuit 138, and the operating power supply voltage change value table storage circuit 137 to carry out processing similar to that executed by the IC internal operating power supply voltage set value calculation circuit 130A and the amperage consumption flow rate target correction value calculation module 130B. The arithmetic control circuit 135 thus calculates and outputs the IC internal operating power supply voltage set value to the IC internal power supply circuit 132.

That is, the arithmetic control circuit 135 comprises a power supply voltage set value calculation module configured to change the power supply voltage generated by the IC internal power supply circuit 132 so as to determine the amperage consumption measured value ITL measured by the coulomb counter circuit for the time interval TL, to be the amperage consumption target value TTL.

The power supply voltage set value calculation module converts the amperage consumption target value TTL into the amperage consumption target value TTS, that is, the target value for the amperage consumption for the time interval TS. The power supply voltage set value calculation module compares the second amperage consumption target value TTS with the amperage consumption measured value ITS based on the time interval TS. The power supply voltage set value calculation module then calculates the set value for the power supply voltage generated by the IC internal power supply circuit 132 so as to reduce the difference between the amperage consumption target value TTS and the amperage consumption measured value ITS.

Furthermore, the power supply voltage set value calculation module further comprises limiting module for making the set value for the power supply voltage generated by the IC internal power supply circuit 132, equal to or smaller than the maximum operating power supply voltage of the assembled battery monitoring IC 130 and equal to or greater than the minimum operating power supply voltage of the assembled battery monitoring IC 130.

The assembled battery monitoring IC 130 further comprises amperage consumption flow rate target correction value calculation module for calculating the difference between the amperage consumption target value TTL and the amperage consumption measured value ITL, adding the differences for a plurality of time intervals TL together to calculate an accumulated value, adding the accumulated value to the current amperage consumption target value TTL to correct the amperage consumption target value TTL, and determining the corrected amperage consumption target value TTL to be the amperage consumption target value TTL for the next time interval TL. Upon receiving an instruction to reduce the calculated accumulated value to zero, the amperage consumption flow rate target correction value calculation module resets the accumulated value to zero.

Now, an example of an operation of setting the amperage consumption target value which operation is performed by the assembled battery management unit 11 will be described.

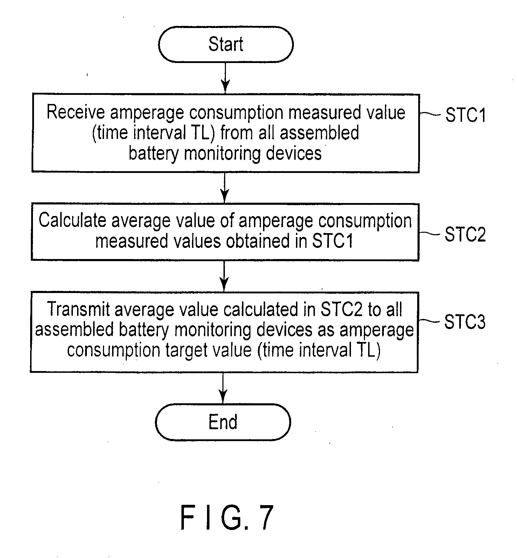

FIG. 7 is a flowchart illustrating an example of an operation performed by the assembled battery management unit 11 in setting the amperage consumption target value TTL for the first time.

First, after the first time interval TL elapses, the assembled battery management unit 11 receives the amperage consumption (amperage consumption measured value ITL) measured, for the time interval TL, by the coulomb counter circuit 139 in the assembled battery monitoring IC 130, from all the assembled battery monitoring devices 13a to 13c (step STC1).

Subsequently, the assembled battery management unit 11 calculates the average value of the amperage consumption measured values ITL received from the assembled battery monitoring devices 13a to 13c (step STC2).

The assembled battery management unit 11 transmits the calculated average value of the amperage consumption measured values ITL to all the assembled battery monitoring devices 13a to 13c via the communication bus 110 as an initial value for the amperage consumption target value TTL (step STC3).

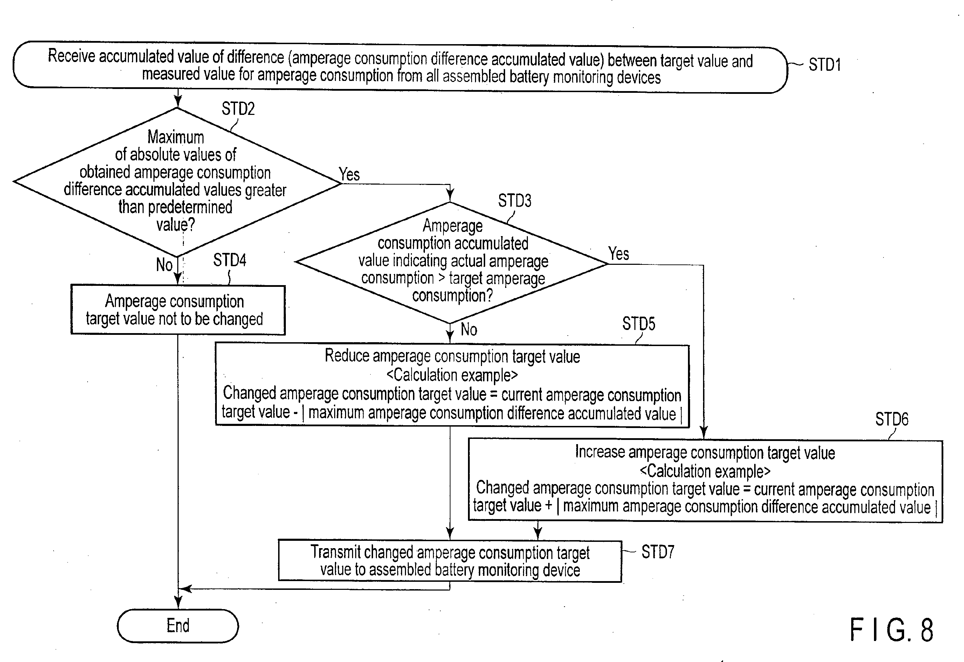

FIG. 8 is a flowchart illustrating an example of an operation performed by the assembled battery management unit 11 in setting the amperage consumption target value TTL for the second and subsequent times.

First, the assembled battery management unit 11 receives the amperage consumption measured value ITL for each time interval TL and the accumulated value (amperage consumption difference accumulated value ATL) of the difference between the actual amperage consumption measured value ITL and the amperage consumption target value TTL for each time interval TL up to the last time interval TL, from all the assembled battery monitoring devices 13a to 13c via the communication bus 110 (step STD1).

The assembled battery management unit 11 determines whether or not the absolute value of the maximum of the amperage consumption difference accumulated values ATL received from the assembled battery monitoring devices 13a to 13c is greater than a predetermined value set in the assembled battery management unit 11 (step STD2).

If the absolute value of the maximum of the amperage consumption difference accumulated values ATL is equal to or smaller than a predetermined value, the assembled battery management unit 11 avoids changing the amperage consumption target value TTL (step STD4).

If the absolute value of the maximum of the amperage consumption difference accumulated values ATL is greater than the predetermined value, the assembled battery management unit 11 determines, based on the sign of the predetermined amperage consumption difference accumulated value, whether or not the maximum of the predetermined amperage difference indicates that the amperage consumption measured value (actual amperage consumption) ITL is greater than the amperage consumption target value TTL (step STD3).

If the amperage consumption measured value ITL is equal to or smaller than the amperage consumption target value TTL, the assembled battery management unit 11 reduces the changed amperage consumption target value TTL (step STD5). For example, the assembled battery management unit 11 determines the changed amperage consumption target value to be the current amperage consumption target value TTL minus the absolute value of the maximum of the amperage consumption difference accumulated value ATL.

If the amperage consumption measured value ITL is greater than the amperage consumption target value TTL, the assembled battery management unit 11 increases the changed amperage consumption target value TTL (step STD6). For example, the assembled battery management unit 11 determines the changed amperage consumption target value to be the current amperage consumption target value TTL plus the absolute value of the maximum of the amperage consumption difference accumulated value ATL.

After calculating the changed amperage consumption target value TTL, the assembled battery management unit 11 transmits the changed amperage consumption target value TTL to each of the assembled battery monitoring devices 13a to 13c via the communication bus 110 (step STD7).

The embodiment allows the amperage consumption of the assembled battery monitoring IC 130 to be set closer to the amperage consumption target value transmitted to each of the assembled battery monitoring devices 13a to 13c by the assembled battery management unit. The amperage consumption of the assembled battery monitoring IC 130 is almost the same as the amperage consumption of each of the assembled battery monitoring devices 13a to 13c. Thus, the amperage consumption of each of the assembled battery monitoring devices 13a to 13c can be set closer to the amperage consumption target value transmitted to the assembled battery monitoring device.

Moreover, the difference in amperage consumption among the assembled battery monitoring devices 13a to 13c can be reduced. This eliminates the need for an inter-assembled-battery balance control circuit required to suppress a variation in voltage among the assembled batteries caused by a difference in amperage consumption among the assembled battery monitoring devices 13a to 13c.

The inter-assembled-battery balance control circuit requires high voltage, surge resistance, and onboard quality and thus requires not only higher area cost but also higher design cost than the circuit mounted in the assembled battery monitoring IC 130 shown in FIG. 3.

In addition, the amperage consumption for all the assembled battery monitoring devices 13a to 13c can be set to the intermediate value of all the amperage consumptions. This allows wasteful amperage consumption for balancing to be suppressed, enabling a reduction in ineffectively available battery capacity.

That is, the embodiment can provide an assembled battery monitoring device, a secondary battery battery monitoring device, a secondary battery apparatus, and a vehicle which enable a reduction in wasteful amperage consumption for balancing, resulting in an increase in effectively available battery capacity.

While certain embodiments have been described, these embodiments have been presented by way of example only, and are not intended to limit the scope of the inventions.

## Claims

1. An assembled battery monitoring device (13) **characterized by** comprising:
an assembled battery monitoring device power supply circuit (131) which is powered by an assembled battery (14) comprising a plurality of secondary battery cells; and
an assembled battery monitoring IC (130) powered by the assembled battery monitoring device power supply circuit (131),
wherein the assembled battery monitoring IC (130) comprises:
a coulomb counter circuit (139) configured to measure internal amperage consumption;
an IC internal power supply circuit (132) powered by the assembled battery monitoring device power supply circuit (131) to generate a power supply voltage for use for an internal operation; and
a power supply voltage set value calculation module (130A) configured to calculate a set value for a power supply voltage generated by the IC internal power supply circuit (132) so as to determine a first amperage consumption target value (TTL) to be a first amperage consumption measured value (ITL) measured at the first time interval (TL) by the coulomb counter circuit (139).

2. The assembled battery monitoring device (13) according to Claim 1, **characterized in that** the coulomb counter circuit (139) measures a second amperage consumption measured value (ISL) for a second time interval (SL) shorter than the first time interval (TL), and
the power supply voltage set value calculation module (130A) converts the first amperage consumption target value (TTL) into a second amperage consumption target value (TTS) which is a target value for amperage consumption for the second time interval (TS), compares the second amperage consumption target value (TTS) with the second amperage consumption measured value (ITS) based on the second time interval (TS), and changes the power supply voltage generated by the IC internal power supply circuit (132) so as to reduce a difference between the second amperage consumption target value (TTS) and the second amperage consumption measured value (ITS).

3. The assembled battery monitoring device according to Claim 2, **characterized by** further comprising a table storage circuit (137) configured to store a table which defines a range of change in the power supply voltage of the IC internal power supply circuit (132) with respect to the internal amperage consumption,
wherein the power supply voltage set value calculation module (130A) references the table to acquire a range of change in the power supply voltage of the IC internal power supply circuit (132) with respect to a difference between the second amperage consumption target value (TTS) and the second amperage consumption measured value (ITS).

4. The assembled battery monitoring device (13) according to any one of Claims 1 to 3, **characterized in that** the power supply voltage set value calculation module (130A) further comprises a limiting module (A4) configured to make the set value for the power supply voltage generated by the IC internal operating power supply circuit, equal to or smaller than a maximum operating power supply voltage and equal to or greater than a minimum operating power supply voltage.

5. The assembled battery monitoring device (13) according to any one of Claims 1 to 4, **characterized in that** the assembled battery monitoring IC (130) further comprises an amperage consumption flow rate target correction value calculation module (130B) configured to calculate a difference between the first amperage consumption target value (TTL) and the first amperage consumption measured value (ITL), adding the differences for a plurality of the first time intervals (TL) together to calculate an accumulated value, adding the accumulated value to the current first amperage consumption target value (TTL) to correct the first amperage consumption target value, and determining the corrected first amperage consumption target value to be the first amperage consumption target value for the next first time interval.

6. The assembled battery monitoring device (13) according to Claim 5, **characterized in that** the amperage consumption flow rate target correction value calculation module (130B) reduces the accumulated value to zero upon receiving an instruction to reduce the accumulated value to zero.

7. A secondary battery apparatus (1) **characterized by** comprising:
a plurality of the assembled batteries (14) each comprising a plurality of secondary battery cells;
a plurality of the assembled battery monitoring devices (13) according to any one of Claim 1 to Claim 6; and
an assembled battery management unit (11) configured to transmit a first power amperage consumption target value (TTL) to the assembled battery monitoring devices (13);
wherein each of the assembled battery monitoring devices (13) transmits the first amperage consumption measured value (TTL) for each of the first time intervals (TL) to the assembled battery management unit (11), and
the assembled battery management unit (11) uses the amperage consumptions received from the assembled battery monitoring devices (13) to calculate the first amperage consumption target value (TTL).

8. The secondary battery apparatus (1) according to Claim 7, **characterized in that** in setting the first amperage consumption target value (TTL) for the first time, the assembled battery management unit (11) determines an average value of the first amperage consumption measured values transmitted by the assembled battery monitoring devices (13) to be the first amperage consumption target value (TTL) after the first time interval elapses.

9. The secondary battery apparatus (1) according to Claim 8, **characterized in that** each of the assembled battery monitoring devices (13) transmits an accumulated value of a difference between the first amperage consumption target value (TTL) and the first amperage consumption measured value (ITL) for each of the first time intervals (TL), and
the assembled battery management unit (11) determines whether or not an absolute value of a maximum of the accumulated values transmitted by the assembled battery monitoring devices (13) is greater than a predetermined value, and changes the first amperage consumption target value (TTL) and transmits the changed first amperage consumption target value to the assembled battery monitoring device (13) if the absolute value of the maximum of the accumulated values is greater than the predetermined value.

10. The secondary battery apparatus (1) according to Claim 9, **characterized in that** when the absolute value of the maximum of the accumulated values is greater than the predetermined value, the assembled battery management unit (11) further determines whether or not an amperage consumption measured the first time interval (TL) after a point of the maximum value of the accumulated values, and increases the first amperage consumption target value (TTL) when the first amperage consumption measured value (ITL) is greater than the first amperage consumption target value (TTL), while reducing the first amperage consumption target value (TTL) when the first amperage consumption measured value(ITL) is equal to or smaller than the first amperage consumption target value (TTL).

11. A vehicle **characterized by** comprising:
the secondary battery apparatus (1) according to any one of Claim 7 to Claim 10; and
an axle driven by power from the secondary battery apparatus (1).

## Patentansprüche

1. Batteriemodul-Überwachungsvorrichtung (13), **gekennzeichnet durch**
eine Batteriemodul-Überwachungsvorrichtung-Leistungsversorgungsschaltung (131), die **durch** ein Batteriemodul (14) mit einer Mehrzahl von sekundären Batteriezellen mit Energie versorgt wird; und
ein Batteriemodul-Überwachungs-IC (130), das **durch** die Batteriemodul-Überwachungsvorrichtung-Leistungsversorgungsschaltung (131) mit Energie versorgt wird, wobei das Batteriemodul-Überwachungs-IC (130) umfasst:
eine Ladezählerschaltung (139), die konfiguriert ist, um den internen Ampereverbrauch zu messen;
eine interne IC-Leistungsversorgungsschaltung (132), die durch die Batteriemodul-Überwachungsvorrichtungs-Leistungsversorgungsschaltung (131) mit Energie versorgt wird, um eine Leistungsversorgungsspannung zur Verwendung für einen internen Betrieb zu erzeugen; und
ein Leistungsversorgungsspannung-Sollwert-Berechnungsmodul (130A), das konfiguriert ist, um einen Sollwert für eine Leistungsversorgungsspannung zu berechnen, die **durch** die interne IC-Leistungsversorgungsschaltung (132) erzeugt wird, um einen ersten Ampereverbrauch-Zielwert (TTL) zu bestimmen, um ein erster Ampereverbrauch-Messwert (ITL) zu sein, der bei dem ersten Zeitintervall (TL) **durch** die Ladezählerschaltung (139) gemessen wird.

2. Batteriemodul-Überwachungsvorrichtung (13) gemäß Anspruch 1, **dadurch gekennzeichnet, dass** die Ladezählerschaltung (139) einen zweiten Ampereverbrauch-Messwert (ISL) für einen zweiten Zeitintervall (SL) misst, der kürzer als das erste Zeitintervall (TL) ist, und
das Leistungsversorgungsspannung-Sollwert-Berechnungsmodul (130A) den ersten Ampereverbrauch-Zielwert (TTL) in einen zweiten Ampereverbrauch-Zielwert (TTS) umwandelt, der ein Zielwert für den Ampereverbrauch für das zweite Zeitintervall (TS) ist, den zweiten Ampereverbrauch-Zielwert (TTS) mit dem zweiten Ampereverbrauch-Messwert (ITS) basierend auf dem zweiten Zeitintervall (TS) vergleicht, und die Leistungsversorgungsspannung ändert, die durch die interne IC-Leistungsversorgungsschaltung (132) erzeugt wurde, um eine Differenz zwischen dem zweiten Ampereverbrauch-Zielwert (TTS) und dem zweiten Ampereverbrauch-Messwert (ITS) zu verringern.

3. Batteriemodul-Überwachungsvorrichtung gemäß Anspruch 2, ferner **gekennzeichnet durch** eine Tabellenspeicherschaltung (137), die konfiguriert ist, um eine Tabelle zu speichern, welche einen Änderungsbereich in der Leistungsversorgungsspannung der internen IC-Leistungsversorgungsschaltung (132) bezüglich des internen Ampereverbrauchs definiert,
wobei das Leistungsversorgungsspannung-Sollwert-Berechnungsmodul (130A) die Tabelle referenziert, um einen Änderungsbereich in der Leistungsversorgungsspannung der internen IC-Leistungsversorgungsschaltung (132) bezüglich einer Differenz zwischen dem zweiten Ampereverbrauch-Zielwert (TTS) und dem zweiten Ampereverbrauch-Messwert (ITS) zu erfassen.

4. Batteriemodul-Überwachungsvorrichtung (13) gemäß einem der Ansprüche 1 bis 3, **dadurch gekennzeichnet, dass** das Leistungsversorgungsspannungs-Sollwert-Berechnungsmodul (130A) ferner ein Begrenzungsmodul (A4) umfasst, das konfiguriert ist, um den Sollwert für die Leistungsversorgungsspannung, der durch die interne IC-Betriebsleistungsversorgungsschaltung erzeugt wurde, gleich oder kleiner als eine maximale Betriebsstromversorgungsspannung und gleich oder größer als eine minimale Betriebsstromversorgungsspannung zu machen.

5. Batteriemodul-Überwachungsvorrichtung (13) gemäß einem der Ansprüche 1 bis 4, **dadurch gekennzeichnet, dass** das Batteriemodul-Überwachungs-IC (130) ferner ein Ampereverbrauch-Flussraten-Zielkorrekturwert-Berechnungsmodul (130B) umfasst, das konfiguriert ist, um eine Differenz zwischen dem ersten Ampereverbrauch-Zielwert (TTL) und dem ersten Ampereverbrauch-Messwert (ITL) zu berechnen, die Differenzen für eine Mehrzahl der ersten Zeitintervalle (TL) zu summieren, um einen akkumulierten Wert zu berechnen, den akkumulierten Wert zu dem aktuellen ersten Ampereverbrauch-Zielwert (TTL) zu addieren, um den ersten Ampereverbrauch-Zielwert zu korrigieren, und den korrigierten ersten Ampereverbrauch-Zielwert zu bestimmen, um der erste Ampereverbrauch-Zielwert für das nächste erste Zeitintervall zu sein.

6. Batteriemodul-Überwachungsvorrichtung (13) gemäß Anspruch 5, **dadurch gekennzeichnet, dass** das Ampereverbrauch-Flussraten-Zielkorrekturwert-Berechnungsmodul (130B) den akkumulierten Wert auf Null verringert bei Empfangen einer Anweisung, den akkumulierten Wert auf Null zu verringern.

7. Sekundäre Batterievorrichtung (1), **gekennzeichnet durch**
eine Mehrzahl der Batteriemodule (14), die jeweils eine Mehrzahl von sekundären Batteriezellen umfassen;
eine Mehrzahl der Batteriemodul-Überwachungsvorrichtungen (13) gemäß einem der Ansprüche 1 bis 6; und
eine Batteriemodul-Verwaltungseinheit (11), die konfiguriert ist, um einen ersten Leistungs-Ampereverbrauch-Zielwert (TTL) an die Batteriemodul-Überwachungsvorrichtungen (13) zu übertragen;
wobei jede der Batteriemodul-Überwachungsvorrichtungen (13) den ersten Ampereverbrauch-Messwert (TTL) für jedes der ersten Zeitintervalle (TL) an die Batteriemodul-Verwaltungseinheit (11) überträgt, und
die Batteriemodul-Verwaltungseinheit (11) die von den Batteriemodul-Überwachungsvorrichtungen (13) empfangenen Ampereverbräucheverwendet, um den ersten Ampereverbrauch-Zielwert (TTL) zu berechnen.

8. Sekundäre Batterievorrichtung (1) gemäß Anspruch 7, **dadurch gekennzeichnet, dass** beim erstmaligen Einstellen des ersten Ampereverbrauch-Zielwerts (TTL) die Batteriemodul-Verwaltungseinheit (11) einen Mittelwert der ersten Ampereverbrauch-Messwerte bestimmt, die durch die Batteriemodul-Überwachungsvorrichtungen (13) übertragen wurden, um der erste Ampereverbrauch-Zielwert (TTL) zu sein, nachdem das erste Zeitintervall abläuft.

9. Sekundäre Batterievorrichtung (1) gemäß Anspruch 8, **dadurch gekennzeichnet, dass** jede der Batteriemodul-Überwachungsvorrichtungen (13) einen akkumulierten Wert einer Differenz zwischen dem ersten Ampereverbrauch-Zielwert (TTL) und dem ersten Ampereverbrauch-Messwert (ITL) für jedes der ersten Zeitintervalle (TL) überträgt, und
die Batteriemodul-Verwaltungseinheit (11) bestimmt, ob ein Absolutwert eines Maximums der akkumulierten Werte, die durch die Batteriemodul-Überwachungsvorrichtungen (13) übertragen wurden, größer als ein vorbestimmter Wert ist oder nicht, und den ersten Ampereverbrauch-Zielwert (TTL) ändert und den geänderten ersten Ampereverbrauch-Zielwert an die Batteriemodul-Überwachungsvorrichtung (13) überträgt, falls der Absolutwert des Maximums der akkumulierten Werte größer als der vorbestimmte Wert ist.

10. Sekundäre Batterievorrichtung (1) gemäß Anspruch 9, **dadurch gekennzeichnet, dass**, wenn der Absolutwert des Maximums der akkumulierten Werte größer als der vorbestimmte Wert ist, die Batteriemodul-Verwaltungseinheit (11) ferner bestimmt, ob ein Ampereverbrauch bei dem ersten Zeitintervall (TL) nach einem Punkt des maximalen Werts der akkumulierten Werte gemessen wurde oder nicht, und den ersten Ampereverbrauch-Zielwert (TTL) erhöht, wenn der erste Ampereverbrauch-Messwert (ITL) größer als der erste Ampereverbrauch-Zielwert (TTL) ist, wohingegen der erste Ampereverbrauch-Zielwert (TTL) verringert wird, wenn der erste Ampereverbrauch-Messwert (ITL) gleich oder kleiner als der erste Ampereverbrauch-Zielwert (TTL) ist.

11. Fahrzeug, **gekennzeichnet durch**
die sekundäre Batterievorrichtung (1) gemäß einem der Ansprüche 7 bis 10; und
eine Achse, die **durch** Leistung von der sekundären Batterievorrichtung (1) angetrieben wird.

## Revendications

1. Dispositif de surveillance de batterie assemblée (13) **caractérisé en ce qu'**il comprend :
un circuit d'alimentation électrique (131) de dispositif de surveillance de batterie assemblée qui est alimenté par une batterie assemblée (14) comprenant une pluralité de cellules de batterie secondaire ; et
un circuit IC de surveillance de batterie assemblée (130) alimenté par le circuit d'alimentation électrique (131) de dispositif de surveillance de batterie assemblée,
dans lequel le circuit IC de surveillance de batterie assemblée (130) comprend :
un circuit de compteur de coulomb (139) configuré pour mesurer la consommation d'intensité de courant interne ;
un circuit d'alimentation électrique interne de IC (132) alimenté par le circuit d'alimentation électrique (131) de dispositif de surveillance de batterie assemblée pour générer une tension d'alimentation électrique destinée à être utilisée pour un fonctionnement interne ; et
un module de calcul de valeur de consigne de tension d'alimentation électrique (130A) configuré pour calculer une valeur de consigne pour une tension d'alimentation électrique générée par le circuit d'alimentation électrique interne de IC (132) de manière à déterminer une première valeur cible de consommation d'intensité de courant (TTL) pour être une première valeur mesurée de consommation d'intensité de courant (ITL) mesurée au premier intervalle de temps (TL) par le circuit de compteur de coulomb (139).

2. Dispositif de surveillance de batterie assemblée (13) selon la revendication 1, **caractérisé en ce que** le circuit de compteur de coulomb (139) mesure une deuxième valeur mesurée de consommation d'intensité de courant (ISL) pour un deuxième intervalle de temps (SL) plus court que le premier intervalle de temps (TL), et
le module de calcul de valeur de consigne de tension d'alimentation électrique (130A) convertit la première valeur cible de consommation d'intensité de courant (TTL) en une deuxième valeur cible de consommation d'intensité de courant (TTS) qui représente une valeur cible de consommation d'intensité de courant pour le deuxième intervalle de temps (TS), compare la deuxième valeur cible de consommation d'intensité de courant (TTS) à la deuxième valeur mesurée de consommation d'intensité de courant (ITS) sur la base du deuxième intervalle de temps (TS), et modifie la tension d'alimentation électrique générée par le circuit d'alimentation électrique interne de IC (132) de manière à réduire une différence entre la deuxième valeur cible de consommation d'intensité de courant (TTS) et la deuxième valeur mesurée de consommation d'intensité de courant (ITS).

3. Dispositif de surveillance de batterie assemblée selon la revendication 2, **caractérisé en ce qu'**il comprend en outre un circuit de stockage de table (137) configuré pour stocker une table qui définit une plage de variation de la tension d'alimentation électrique du circuit d'alimentation électrique interne de IC (132) par rapport à la consommation d'intensité de courant interne,
dans lequel le module de calcul de valeur de consigne de tension d'alimentation électrique (130A) fait référence à la table pour acquérir une plage de variation de la tension d'alimentation électrique du circuit d'alimentation électrique interne de IC (132) par rapport à une différence entre la deuxième valeur cible de consommation d'intensité de courant (TTS) et la deuxième valeur mesurée de consommation d'intensité de courant (ITS).

4. Dispositif de surveillance de batterie assemblée (13) selon l'une quelconque des revendications 1 à 3, **caractérisé en ce que** le module de calcul de valeur de consigne de tension d'alimentation électrique (130A) comprend en outre un module de limitation (A4) configuré pour rendre la valeur de consigne de la tension d'alimentation électrique générée par le circuit d'alimentation électrique de fonctionnement interne de IC, inférieure ou égale à une tension maximale d'alimentation électrique de fonctionnement et supérieure ou égale à une tension minimale d'alimentation électrique de fonctionnement.

5. Dispositif de surveillance de batterie assemblée (13), selon l'une quelconque des revendications 1 à 4, **caractérisé en ce que** le circuit IC de surveillance de batterie assemblée (130) comprend en outre un module de calcul de valeur de correction cible de débit de consommation d'intensité de courant (130B) configuré pour calculer une différence entre la première valeur cible de consommation d'intensité de courant (TTL) et la première valeur mesurée de consommation d'intensité de courant (ITL), additionner les différences pour une pluralité des premiers intervalles de temps (TL) ensemble pour calculer une valeur cumulée, ajouter la valeur cumulée à la première valeur cible actuelle de consommation d'intensité de courant (TTL) pour corriger la première valeur cible de consommation d'intensité de courant, et déterminer la première valeur cible de consommation d'intensité de courant corrigée pour être la première valeur cible de consommation d'intensité de courant pour le premier intervalle de temps suivant.

6. Dispositif de surveillance de batterie assemblée (13) selon la revendication 5, **caractérisé en ce que** le module de calcul de valeur de correction cible de débit de consommation d'intensité de courant (130B) réduit la valeur cumulée à zéro lors de la réception d'une instruction pour réduire la valeur cumulée à zéro.

7. Appareil à batterie secondaire (1)
**caractérisé en ce qu'**il comprend :
une pluralité des batteries assemblées (14) comprenant chacune une pluralité de cellules de batterie secondaire ;
une pluralité des dispositifs de surveillance de batterie assemblée (13) selon l'une quelconque des revendication 1 à 6 ; et
une unité de gestion de batterie assemblée (11) configurée pour transmettre une première valeur cible de consommation d'intensité de courant (TTL) aux dispositifs de surveillance de batterie assemblée (13) ;
dans lequel chacun des dispositifs de surveillance de batterie assemblée (13) transmet la première valeur mesurée de consommation d'intensité de courant (TTL) pour chacun des premiers intervalles de temps (TL) à l'unité de gestion de batterie assemblée (11), et
l'unité de gestion de batterie assemblée (11) utilise des consommations d'intensité de courant reçues à partir des dispositifs de surveillance de batterie assemblée (13) pour calculer la première valeur cible de consommation d'intensité de courant (TTL).

8. Appareil à batterie secondaire (1) selon la revendication 7, **caractérisé en ce que**, à l'établissement de la première valeur cible de consommation d'intensité de courant (TTL) pour la première fois, l'unité de gestion de batterie assemblée (11) détermine une valeur moyenne des premières valeurs mesurées de consommation d'intensité de courant transmises par les dispositifs de surveillance de batterie assemblée (13) pour être la première valeur cible de consommation intensité de courant (TTL) après que le premier intervalle de temps s'est écoulé.

9. Appareil à batterie secondaire (1) selon la revendication 8, **caractérisé en ce que** chacun des dispositifs de surveillance de batterie assemblée (13) transmet une valeur cumulée d'une différence entre la première valeur cible de consommation d'intensité de courant (TTL) et la première valeur mesurée de consommation d'intensité de courant (ITL) pour chacun des premiers intervalles de temps (TL), et
l'unité de gestion de batterie assemblée (11) détermine si une valeur absolue d'une valeur maximale des valeurs cumulées transmises par les dispositifs de surveillance de batterie assemblée (13) est supérieure ou non à une valeur prédéterminée, et modifie la première valeur cible de consommation d'intensité de courant (TTL) et transmet la première valeur cible modifiée de consommation d'intensité de courant au dispositif de surveillance de batterie assemblée (13) si la valeur absolue de la valeur maximale des valeurs cumulées est supérieure à la valeur prédéterminée.

10. Appareil à batterie secondaire (1) selon la revendication 9, **caractérisé en ce que** lorsque la valeur absolue de la valeur maximale des valeurs cumulées est supérieure à la valeur prédéterminée, l'unité de gestion de batterie assemblée (11) détermine en outre si la consommation d'intensité de courant a été mesurée dans le premier intervalle de temps (TL) après un point de la valeur maximale des valeurs cumulées ou non, et augmente la première valeur cible de consommation d'intensité de courant (TTL) lorsque la première valeur mesurée de consommation d'intensité de courant (ITL) est supérieure à la première valeur cible de consommation d'intensité de courant (TTL), tout en diminuant la première valeur cible de consommation d'intensité de courant (TTL) lorsque la première valeur mesurée de consommation d'intensité de courant (ITL) est inférieure ou égale à la première valeur cible de consommation d'intensité de courant (TTL).

11. Véhicule **caractérisé en ce qu'**il comprend :
l'appareil à batterie secondaire (1) selon l'une quelconque des revendications 7 à 10 ; et
un essieu entraîné par la puissance provenant de l'appareil à batterie secondaire (1).
